Europäisches Patentamt

European Patent Office

Office européen des brevets

(19)

(11) Numéro de publication: **0 007 873**
**B1**

(12) **FASCICULE DE BREVET EUROPEEN**

(45) Date de publication du fascicule de brevet: **04.11.81**

(51) Int. Cl.³: **B 23 K 35/26, H 01 L 21/60**

(21) Numéro de dépôt: **79400530.6**

(22) Date de dépôt: **25.07.79**

(54) **Système de soudure d'un composant semiconducteur émetteur de lumière sur un socle métallique.**

(30) Priorité: **25.07.78 FR 7821969**

(43) Date de publication de la demande:
**06.02.80 Bulletin 80/3**

(45) Mention de la délivrance du brevet:
**04.11.81 Bulletin 81/44**

(84) Etats Contractants Désignés:
**DE GB IT NL**

(56) Documents cités:
**FR - A - 1 366 349**
**FR - A - 1 515 415**
**FR - A - 2 235 752**
**FR - A - 2 306 528**

**I.E.E.E. TRANSACTIONS ON ELECTRON
DEVICES, Vol. 23, n° 8, août 1976,
NEW YORK (US)
N.D. ZOMMER et al.: "Reliability and Thermal
Impedance Studies in Soft Soldered
Power Transistors",
pages 843—850**

(73) Titulaire: **THOMSON-CSF
173, Boulevard Haussmann
F-75360 Paris Cedex 08 (FR)**

(72) Inventeur: **Duda, Eugène
"THOMSON-CSF" - SCPI 173, bld Haussmann
F-75360 Paris Cedex 08 (FR)**
Inventeur: **Maumy, Alain
"THOMSON-CSF" - SCPI 173, bld Haussmann
F-75360 Paris Cedex 08 (FR)**
Inventeur: **Tondu, Claude
"THOMSON-CSF" - SCPI 173, bld Haussmann
F-75360 Paris Cedex 08 (FR)**

(74) Mandataire: **Wang, Pierre et al,
"THOMSON-CSF" - SCPI 173, bld. Haussmann
F-75360 Paris Cedex 08 (FR)**

Courier Press, Leamington Spa, England.

## Système de soudure d'un composant semiconducteur émetteur de lumière
## sur un socle métallique

Le problème se pose de souder une diode électroluminescente et plus particulièrement une diode "laser" sur un socle dissipateur de la chaleur et conducteur de l'électricité.

Un matériau bien approprié pour la fabrication du socle est le cuivre. L'assemblage d'un matériau semi-conducteur et du cuivre pose le problème de la différence de coefficients de dilatation, qui sont la cause de contraintes lors du fonctionnement. On a jusqu'à présent utilisé pour la soudre l'indium qui est un métal mou, et qui permet de minimiser ces contraintes. Malheureusement, l'indium forme avec la plupart des métaux, des alliages modifiant profondément ses propriétés physiques ce qui altère les soudres.

Pour permettre l'utilisation comme métal de liaison d'un métal mou tel que le plomb, on a proposé dans une demande de brevet déposée en France et publiée sous le N° 2 306 528 de munir les deux faces à relier d'une couche de métal faisant office de barrière anti-diffusion vis-à-vis du métal de liaison. Pour favoriser le mouillage du métal de barrage par le métal de liaison on forme un hydrure métallique avant de procéder à la soudure pour éviter les inconvénients de l'oxidation. Ces inconvénients peuvent être évités au moyen d'une couche superficielle de métal précieux comme décrit à propos d'une prise de contact dans le brevet français N° 1.515.415.

L'invention se rapporte à un système d'assemblage de composant semiconducteur émetteur de lumière avec un corps métallique, qui tout en utilisant l'indium comme couche intermédiaire, permet d'éviter ces inconvénients. Elle a pour objet un système de soudure d'un composant semiconducteur émetteur de lumière avec un support métallique, ledit système comprenant une couche d'un métal de liaison mou reliant entre eux des dépôts effectués respectivement sur la face d'appui du composant semiconducteur et sur l'assise du support métallique; chacun desdits dépôts comprenant une première couche d'un métal faisant office de barrière anti-diffusion vis-à-vis dudit métal de liaison et une seconde couche assurant un bon mouillage du métal anti-diffusion par ledit métal de liaison, caractérisé en ce que ledit métal de liaison est l'indium; ledit métal de barrage étant le tungstène et ledit métal mouillant étant l'or.

L'invention sera mieux comprise au moyen de la description ci-après en se référant aux dessins annexés parmi lesquels:

— la figure 1 montre en perspective un exemple de réalisation de l'invention;

— la figure 2 représente un détail de la figure 1.

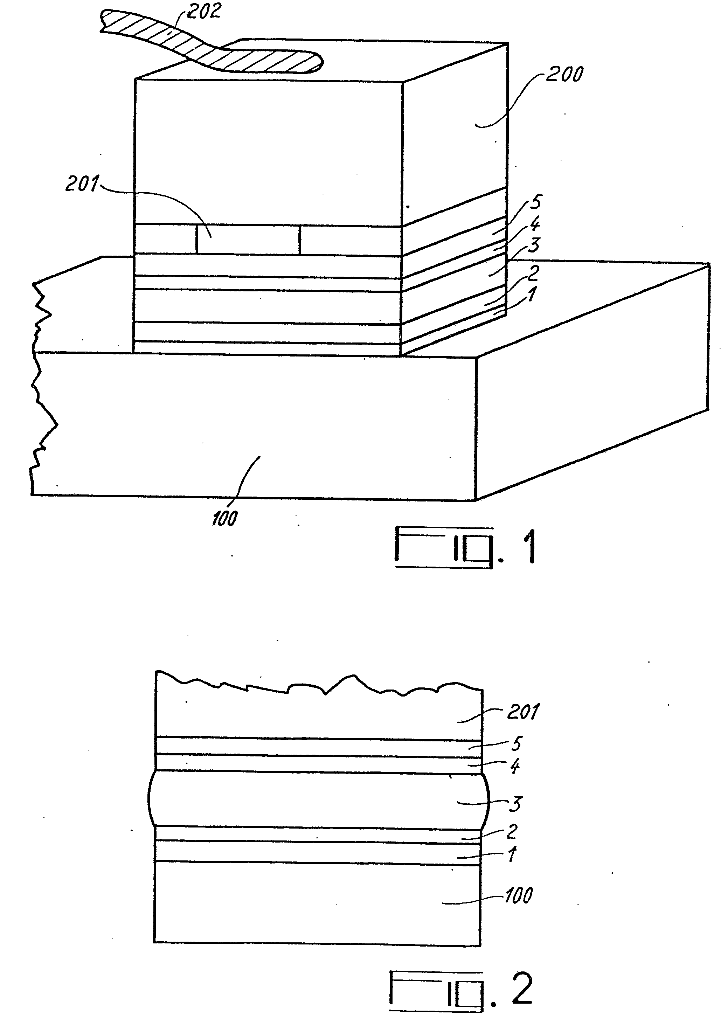

Sur la figure 1, on voit en perspective une diode "laser" (200) formée de couches épitaxiales à base d'Arséniure de Gallium (GaAs) contenant, suivant les couches, plus ou moins d'aluminium. Cette diode comporte une zone active 201 émettrice de lumière et sur sa face supérieure un contact électrique 202 déposé suivant toute technique connue.

Pour que le fonctionnement d'une telle diode soit correct, il faut qu'elle soit, du côté des couches épitaxiales, soudée sur un support, suffisamment massif et fait d'un matériau bon conducteur de la chaleur, assurant à la fois l'évacuation de la chaleur et le contact électrique.

Ce matériau est avantageusement le cuivre. Malheureusement jusqu'à présent on ne savait pas souder correctement l'Arséniure de Gallium sur le cuivre.

Les soudures les plus intéressantes étaient faites au moyen d'une couche d'indium qui présente l'avantage d'être un métal mou et qui permet ainsi d'éviter les contraintes dues à la différence du coefficient de dilatation de l'AsGa $(5.10^{-6})$ et celui du cuivre $(16.10^{-6})$.

Mais, pour améliorer la qualité des contacts, on est amené d'une part à déposer une couche d'or, sur le cuivre préalablement à la soudure, et d'autre part, des couches d'or ou d'autres métaux sur la surface inférieure du laser. Or l'indium et l'or diffusent très rapidement à la température ambiante. L'or s'alliant à froid avec l'indium, il faut opérer rapidement la soudure en chauffant à une température supérieure au point de fusion de l'indium par exemple 180°C, sinon il se forme un alliage $AuIn_2$ plus dur et dont le point de fusion est de 544°C. La soudure est donc délicate à faire et il en découle un manque de reproductibilité dans la qualité des soudures.

Le même phénomène se reproduit en ce qui concerne le métal déposé sur la diode "laser", le coefficient de dilatation de l'alliage $AuIn_2$ n'est plus approprié, ce qui cause des contraintes thermiques dans le "laser".

Il résulte de ce qui précède que les propriétés de l'Indium sont altérées lors des soudures, ce qui explique que jusqu'à présent on n'a pas eu de résultats convenables dans ce sens.

L'invention permet de remédier à ces inconvénients, tout en conservant l'indium comme métal de soudure.

Sur la figure 2, est représenté le socle de cuivre 100 sur lequel on va pratiquer la soudure.

Sur ce socle a été déposée une couche 1 de tungstène par tout procédé (canon à électrons, pulvérisation cathodique) d'épaisseur de 1000 Angströms environ, puis une couche d'or 2 d'épaisseur de l'ordre de 500 Angströms, enfin est déposée la couche d'indium 3 de 1 à 3 $\mu$m d'épaisseur. La présence de l'or est nécessaire, car l'indium mouille difficilement le tungstène. De même, sur le composant laser est déposée une couche de tungstène de 200 à 1000 Angströms 5, puis une couche 4 d'or de 500 Angströms.

Les couches d'or sont suffisamment minces pour ne pas perturber les propriétés de l'indium, la formation d'AuIn$_2$ étant très limitée. L'épaisseur de la couche de tungstène est optimisée pour limiter les contraintes.

La présence de tungstène sur les deux faces de la soudure évite en grande partie la formation d'alliage d'Indium, ce qui fait que celui-ci joue pleinement son rôle. On obtient ainsi une bonne reproductibilité des soudures, de bons contacts thermiques et électriques, la diminution des contraintes dues à l'absence quasi-totale d'alliage d'Indium, pas de détérioration des contacts au cours de la vie du composant, et enfin la possibilité d'utiliser des "lasers" en fonctionnement à une témpérature de l'ordre de 70°C.

Il est à remarquer que parmi les métaux courants, le tungstène semble être le seul métal capable de constituer une barrière efficace pour la diffusion de l'Indium. De plus, il présente une bonne conductibilité thermique de l'ordre de 1,8 W/cm-°C.

Enfin, les couches d'or et d'Indium doivent être localisées sous le laser de façon à éviter toute diffusion latérale de l'Indium.

## Revendications

1. Système de soudure d'un composant semiconducteur (201) émetteur de lumière avec un support métallique (100), ledit système comprenant une couche (3) d'un métal de liaison mou reliant entre eux des dépôts effectués respectivement sur la face d'appui du composant semiconducteur et sur l'assise du support métallique; chacun desdits dépôts comprenant une première couche (1, 5) d'un métal faisant office de barrière anti-diffusion vis-à-vis dudit métal de liaison et une seconde couche (2, 4) assurant un bon mouillage du métal anti-diffusion par ledit métal de liaison, caractérisé en ce que ledit métal de liaison (3) est l'indium; ledit métal de barrage (1, 5) étant le tungstène et ledit métal mouillant (2, 4) étant l'or.

2. Système selon la revendication 1, caractérisé en ce que le composant semiconducteur (201) est à base d'Arséniure de Gallium GaAs.

3. Système selon la revendication 1, caractérisé en ce que la couche d'indium (3) a une épaisseur de l'ordre de 1 à 10 $\mu$m, les deux couches (1, 5) de tungstène une épaisseur de l'ordre de 0,02 à 0,1 $\mu$m, les deux couches d'or (2, 4) une épaisseur de l'ordre de 0,05 $\mu$m à 0,10 $\mu$m.

4. Système de soudure selon la revendication 1, caractérisé en ce que les couches de barrage (1, 5) sont localisées sous le composant (201) ce qui empêche la diffusion latérale du métal de liaison (3).

5. Dispositif d'optique intégrée, caractérisé en ce qu'il comporte des systèmes de soudure suivant une des revendications 1, 2, 3 et 4.

## Claims

1. Welding joint between a light-emitting semiconductor component (201) and a metallic support (100), comprising a layer (3) of a soft binding metal interconnecting the deposits applied respectively onto the resting face of the semiconductor component and the supporting face of said metallic support, each one of said deposits comprising a first layer (1,5) of a metal acting as an anti-diffusion barrier with respect to said binding metal, and a second layer (2,4) ensuring satisfactory wetting of the anti-diffusion metal by said binding metal, characterized in that said binding metal (3) is indium, said barrier metal (1,5) is tungsten and said wetting metal (2,4) is gold.

2. Joint according to claim 1, characterized in that the semiconductor component (201) is based on gallium arsenide GaAs.

3. Joint according to claim 1, characterized in that the indium layer (3) has a thickness of about 1 to 10 $\mu$m, the two tungsten layers (1,5) have a thickness of about 0.02 to 0.1 $\mu$m and the two gold layers (2,4) have a thickness of about 0.05 $\mu$m to 0.10 $\mu$m.

4. Welding joint according to claim 1, characterized in that the barrier layers (1,5) are located under the component (201), whereby lateral diffusion of the binding metal (3) is prevented.

5. Integrated optical device, characterized in that it comprises welding joints according to any one of claims 1, 2, 3 and 4.

## Patentansprüche

1. Schweiss-Struktur zwischen einem Leuchthalbleiterbauteil (201) und einem metallischen Träger (100), mit einer aus einem welchen Bindemetall bestehenden, den auf die Stützfläche des Halbleiterbauteils aufgetragenen Belag und den auf die Tragfläche des metallischen Trägers aufgetragenen Belag miteinander verbindenden Schicht (3), wobei jeder Belag eine erste Schicht (1,5) aus einem gegenüber dem Bindemetall als Diffusionssperrschicht wirkendem Metall, sowie eine zweite Schicht (2,4) aufweist, die eine gute Benetzung des die Diffusionssperrschicht bildenden Metalls durch das Bindemetall bewirkt, dadurch gekennzeichnet, dass das Bindemetall (3) Indium ist, während das die Sperrschicht bildende Metall (1,5) Wolfram ist und das Benetzungsmetall (2,4) Gold ist.

2. Struktur nach Anspruch 1, dadurch gekennzeichnet, dass der Halbleiterbauteil (201) wesentlich Galliumarseniat GaAs enthält.

3. Struktur nach Anspruch 1, dadurch gekennzeichnet, dass die Indiumschicht (3) etwa 1 bis 10 $\mu$m stark ist, während die beiden Wolframschichten (1,5) etwa 0,02 bis 0,1 $\mu$m stark und die beiden Goldschichten (2,4) etwa 0,05 bis 0,10 $\mu$m stark sind.

4. Schweiss-Struktur nach Anspruch 1, dadurch gekennzeichnet, dass die Sperrschichten (1,5) unterhalb des Bauteils (201) angeordnet sind, wodurch eine seitliche Diffusion des Bindemetalls (3) verhütet wird.

5. Integrierte optische Einrichtung, dadurch gekennzeichnet, dass sie Schweiss-Strukturen nach einem der Ansprüche 1, 2, 3 und 4 aufweist.

FIG. 1

FIG. 2

1